# EUROPÄISCHE PATENTANMELDUNG

(11) **EP 0 594 030 A2**
(43) Veröffentlichungstag der Anmeldung: **27.04.1994**
(21) Anmeldenummer: 93116448.7
(22) Anmeldetag: 11.10.1993
(51) Int. Cl.: C30B 29/36, C30B 25/02, H01L 21/36

(54) **Verfahren zur Herstellung eines Wafers mit einer monokristallinen Siliciumcarbidschicht**

(30) Priorität: 13.10.1992 DE 4234508
(71) Anmelder: CS HALBLEITER-UND SOLARTECHNOLOGIE GMBH, D-80339 München (DE)
(72) Erfinder: Scholz, Christoph Dr., D-81669 München (DE); Köhl, Franz Dr., D-84489 Burghausen (DE); Weber, Thomas, D-80686 München (DE)
(74) Vertreter: Haft, von Puttkamer, Berngruber, Czybulka

(57) **Zusammenfassung**

Zur Herstellung eines großflächigen Wafers läßt man auf eine monokristalline Si-Schicht (1), die durch Carbonisieren mit einer Keimbildungsschicht (3) versehen ist, eine monokristalline SiC-Schicht (4) epitaktisch aufwachsen. Auf der monokristallinen SiC-Schicht (4) wird eine polykristalline SiC-Schicht (5) abgeschieden. Anschließend wird die Si-Schicht weggeätzt und ein den höchsten Ansprüchen der Halbleitertechnik genügender Wafer aus einem Verbund von monokristalliner (4) und polykristalliner (5) SiC-Schicht erhalten.

## Beschreibung

Die Erfindung bezieht sich auf ein Verfahren zur Herstellung eines Wafers mit einer monokristallinen Siliciumcarbid-(SiC)-Schicht nach dem Oberbegriff des Anspruchs 1.

Ein derartiges Verfahren ist aus DE 41 09 005 C1 bekannt. In dem durch (Hetero-)Epitaxie-Aufwachsen erhaltenen Verbund aus monokristallinem Silicium-(Si)-Substrat und monokristalliner SiC-Schicht besitzen Si und SiC stark voneinander abweichende Wärmeausdehnungskoeffizienten, und zwar zieht sich SiC beim Abkühlen stärker zusammen als Si. Dies hat zur Folge, daß sich das Substrat stark wölbt, die auf Si aufgewachsene SiC-Schicht reißt oder das Substrat bricht, insbesondere bei Wafern mit größerem Durchmesser. Nach der DE 41 09 005 C1 wird daher der Verbund aus der aufgewachsenen SiC-Schicht und dem Si-Substrat von der Temperatur, bei der das Epitaxie-Aufwachsen durchgeführt wird, also von z.B. 1300 bis 1400°C, nicht abgekühlt, vielmehr wird dieser Verbund weiter aufgeheizt, und zwar vorzugsweise bis knapp unter oder bis über den Schmelzpunkt des Siliciums, wodurch das Si-Substrat von dem Verbund abgeschmolzen bzw. durch Sublimation verdampft wird, so daß ein Wafer aus der monokristallinen SiC-Schicht zurückbleibt. Das bekannte Verfahren hat sich zwar als durchführbar erwiesen. Das Abschmelzen des Si-Substrats ist jedoch in der Praxis mit Problemen behaftet.

Aus JP 55-144500 A ist es bekannt, zur Herstellung einer größeren SiC-Kristall-Schicht ein Si-Substrat nach dem Anätzen mit Chlorwasserstoff durch Gasphasenabscheidung mit einer polykristallinen SiC-Schicht zu beschichten. Anschließend wird das Si-Substrat mit Fluorwasserstoff weggeätzt. Auf die erste SiC-Schicht wird dann aus der Gasphase eine zweite SiC-Schicht abgeschieden, welche ebenfalls polykristallin ist, aber aus orientierten Kristalliten besteht.

Nach JP 55-144500 A wird also zunächst ein Verbund aus einer polykristallinen SiC-Schicht und einer Si-Schicht erhalten. Eine polykristalline Schicht - wenn auch die Kristallite wohl orientiert sind - ist jedoch für Halbleiteranwendungen unbrauchbar.

Das gleiche Problem der starken mechanischen Verspannung, insbesondere bei großflächigen Substraten, tritt bei dem Verfahren nach DE 36 13 012 A1 und DE 34 46 956 A1 auf, wonach eine beta-SiC-Schicht nach dem CVD-Verfahren auf eine monokristalline Si-Schicht aufwachsen gelassen wird, woran sich die Entfernung der Si-Schicht mittels einer Säure anschließt. Auf die monokristalline beta-SiC-Schicht läßt man dann eine monokristalline alpha-SiC-Schicht wachsen.

Aufgabe der Erfindung ist es, ein relativ einfaches Verfahren zur Herstellung großflächiger Wafer mit einer monokristallinen SiC-Schicht anzugeben, welche allen Anforderungen der Halbleiter-Technik genügen.

Dies wird erfindungsgemäß mit dem im Anspruch 1 gekennzeichneten Verfahren erreicht.

Die Erfindung beruht auf der überraschenden Feststellung, daß der Verbund aus aufgewachsener monokristalliner SiC-Schicht und monokristallinem Si-Substrat trotz der sehr unterschiedlichen Wärmeausdehnungskoeffizienten von Si und SiC dann nicht mehr reißt, ja sich nicht einmal mehr nennenswert wölbt, wenn auf der monokristallinen SiC-Schicht dieses Verbundes noch eine polykristalline SiC-Schicht abgeschieden wird, bevor der Verbund abgekühlt wird, um das Si-Substrat wegzuätzen.

Im Gegensatz zu einem Verbund aus einer aufgewachsenen monokristallinen SiC-Schicht auf einem monokristallinem Si-Substrat, der sich beim Abkühlen von der Epitaxie-Aufwachstemperatur von beispielsweise 1300 bis 1400°C auf Raumtemperatur aufgrund der unterschiedlichen Wärmeausdehnungskoeffizienten von SiC und Si stark wölbt und bei dem die monokristalline SiC-Schicht zerbricht, bleibt also ein solcher Verbund beim Abkühlen völlig intakt, wenn man auf die monokristalline SiC-Schicht noch eine polykristalline SiC-Schicht abgeschieden hat.

Wenn das Si-Substrat weggeätzt worden ist, erhält man erfindungsgemäß einen selbsttragenden Wafer aus einem Verbund aus einer monokristallinen SiC-Schicht und einer polykristallinen SiC-Schicht zur Herstellung von Bauelementen (Schaltkreisen).

Durch die unterschiedlichen Gitterparameter und die unterschiedlichen Wärmeausdehnungskoeffizienten von SiC und Si weist die monokristalline SiC-Schicht nach dem Aufwachsen auf den Si-Träger an der Grenzfläche zum Si-Träger allerdings eine relativ große Versetzungsdichte auf, die mit dem Abstand von der Grenzfläche zwar abnimmt, aber dennoch in die gewachsene monokristalline SiC-Schicht hineinreicht.

Vorzugsweise scheidet man daher auf den Verbund aus erster monokristalliner SiC-Schicht und polykristalliner SiC-Schicht auf der ersten monokristallinen SiC-Schicht noch eine zweite monokristalline SiC-Schicht durch Homo-Epitaxie ab. Damit wird ein Wafer mit einer monokristallinen SiC-Schicht höchster Kristallqualität erhalten.

Das Epitaxie-Aufwachsen der monokristallinen SiC-Schicht(en) und das Aufwachsen der polykristallinen SiC-Schicht erfolgt vorzugsweise aus der Gasphase. Dazu werden insbesondere die chemische Gasphasenabscheidung (CVD) und die Molekularstrahl-Epitaxie (MBE) angewendet. Für die Bildung der zweiten monokristallinen SiC-Schicht kann statt einer Gasphasenabscheidung auch ein anderes Abscheidungsverfahren angewendet werden, z. B. die Flüssigphasen-Epitaxie (LPE).

Auch kann man die erste und die zweite monokristalline SiC-Schicht gegebenenfalls unterschiedlich dotieren.

Die Voraussetzung, daß sich auf dem Si-Substrat zunächst eine monokristalline SiC-Schicht bildet (im Gegensatz zu JP 55-144500 A) ist, daß das Si-Substrat vor dem Aufwachsen der monokristallinen SiC-Schicht carbonisiert wird. Dazu wird das Si-Substrat mit einem kohlenstoffhaltigen Gas, insbesondere einem Kohlenwasserstoff, wie Methan, Ethan, Propan, Ethylen oder Acetylen, oder einem halogenhaltigen Kohlenwasserstoff umgesetzt, wodurch sich an der Si-Substratoberfläche eine monokristalline SiC-Keimbildungsschicht bildet, der eine Dicke von bis zu 300 nm, vorzugsweise 20 bis 200 nm, aufweist.

Die Keimbildungsschicht weist allerdings eine relativ hohe Versetzungsdichte auf. Sie wird daher vorzugsweise nach dem Wegätzen der Si-Substratschicht von der monokristallinen SiC-Schicht des Verbundes aus der monokristallinen SiC-Schicht und der polykristallinen SiC-Schicht entfernt.

Dazu kann die Außenseite der monokristallinen SiC-Schicht z.B. einem chemischen Naßätzverfahren, beispielsweise mit einem Gemisch aus Fluorwasserstoff und Salpetersäure, einer thermischen Oxidation oder einem Ionen- oder Plasma-Ätzen ausgesetzt werden.

Das erfindungsgemäße Verfahren wird in einem Reaktor mit einer Kammer durchgeführt, in der das monokristalline Siliciumsubstrat auf einem erwärmbaren Substrathalter angeordnet wird. Der Kammer werden dann nacheinander die entsprechenden gasförmigen Verbindungen im Gemisch mit einem Trägergas zugeführt, mit dem der Verbund aus dem Si-Substrat, der monokristallinen SiC-Schicht, und der polykristallinen SiC-Schicht hergestellt wird.

Als Trägergas wird im allgemeinen Argon, Helium und/oder Wasserstoff verwendet. Als Si-Quelle können Mono- oder Disilane, einschließlich chlorhaltiger Mono- oder Disilane eingesetzt werden, beispielsweise Silan (SiH₄), Tetrachlorsilan (SiCl₄) oder Dichlorsilan (SiCl₂H₂). Als C-Quelle zur Carbonisierung des Si-Substrats sowie zur Bildung von SiC werden vorzugsweise Kohlenwasserstoffe, wie Methan, Ethan, Propan, Ethylen oder Acetylen, verwendet, einschließlich halogenhaltiger Kohlenwasserstoffe.

Zur Bildung der monokristallinen SiC- und der polykristallinen SiC-Schicht wird das Si-Substrat auf dem Substrathalter auf beispielsweise 1300 bis 1400°C erhitzt. Auch können zur Herstellung der monokristallinen SiC-Schicht und zur Herstellung der polykristallinen SiC-Schicht die gleichen Si- und C-Quellen verwendet werden.

Die Bildung der monokristallinen SiC-Schicht erfolgt jedoch im allgemeinen mit einer geringeren Abscheidungsgeschwindigkeit. So beträgt bei Verwendung von CH₄/SiH₄ als C- bzw. Si-Quelle mit einem Volumenverhältnis von z.B. 2:1 und bei einer Temperatur von z.B. 1360°C die Abscheidungsgeschwindigkeit des SiC zur Bildung einer monokristallinen SiC-Schicht höchstens 10 µm/h, während bei sonst gleichen Bedingungen, jedoch einem höheren CH₄/SiH₄-Druck zur Bildung der polykristallinen SiC-Schicht eine Abscheidungsgeschwindigkeit von vorzugsweise mehr als 20 µm/h eingestellt wird.

Das heißt, grundsätzlich ist bei einem höheren Massenfluß der Si- und C-Quelle und/oder einer niedrigeren Temperatur die Bildung von polykristallinem SiC zu erwarten, während bei einem niedrigeren Massenfluß der Si- und C-Quelle und/oder einer höheren Temperatur monokristallines SiC entsteht.

Die Dicke der (ersten) monokristallinen SiC-Schicht des erfindungsgemäßen Wafers beträgt vorzugsweise 0,05 bis 100 µm, insbesondere 0,5 bis 10 µm, die Dicke der polykristallinen SiC-Schicht, die im allgemeinen dicker als die monokristalline SiC-Schicht ist, liegt vorzugsweise bei 5 bis 500 µm, insbesondere 50 bis 150 µm.

Das durch Epitaxie-Aufwachsen auf das monokristalline Si-Substrat erhaltene monokristalline SiC ist vom beta-Typ. Die monokristalline SiC-Schicht kann man sowohl auf die (1 1 1)-Fläche, wie auf die (1 1 0)- oder (1 0 0)-Fläche des Si-Substrats aufwachsen lassen. In keinem Fall ist ein nennenswertes Wölben des Verbundes aus monokristalliner Si-Schicht, monokristalliner SiC-Schicht und polykristalliner SiC-Schicht nach dem Herausnehmen aus der Reaktionskammer und Abkühlen auf Raumtemperatur festzustellen, um dann die Si-Trägerschicht wegzuätzen.

Dies ist deswegen erwähnenswert, weil beim Abkühlen eines Verbundes aus einer monokristallinen SiC-Schicht, die auf einer monokristallinen Si-Schicht aufgewachsen ist, beim Aufwachsen auf die (1 1 1)-Fläche des Si-Substrats eine besonders starke Wölbung des Verbundes und Zerstören der monokristallinen SiC-Schicht festzustellen ist.

Das Wegätzen der Si-Trägerschicht erfolgt vorzugsweise naßchemisch, insbesondere mit einem fluorwasserstoffhaltigen Ätzmittel.

Wenn die Si-Trägerschicht und gegebenenfalls die Keimbildungsschicht weggeätzt worden sind, kann der Verbund aus monokristalliner SiC-Schicht und polykristalliner SiC-Schicht erneut in die Reaktionskammer gegeben werden, um durch Homo-Epitaxie auf die monokristalline SiC-Schicht eine weitere monokristalline SiC-Schicht gleicher oder verschiedener Dotierung aufwachsen zu lassen.

Nach dem erfindungsgemäßen Verfahren können Wafer mit einem Durchmesser von z.B. 15 cm und mehr, also einer Fläche von mehreren 100 cm² mit tadelloser Kristallqualität ohne weiteres hergestellt werden. Mikrorisse konnten selbst bei den bisher hergestellten größten Wafern nicht festgestellt werden. Auch ist die Wölbung der Wafer so gering, daß man sie vernachlässigen kann.

Wie Versuche gezeigt haben, weist ein erfindungsgemäß hergestellte Wafer mit einem Durchmesser von 75 mm aus einem Verbund aus einer monokristallinen SiC-Schicht und einer polykristallinen SiC-Schicht eine Krümmung mit einem Krümmungsradius von größer als 3 m auf. Der Wafer ist also praktisch eben.

Er kann damit auf einen ebenen Substrathalter gegeben und dort beispielsweise durch Ansaugen mit Vakuum gehalten werden. Der ebene Wafer kann damit beispielsweise durch Photolithographie mit einer exakten Schaltkreisstruktur versehen werden.

Die bisher üblichen Wafer aus monokristallinem SiC weisen demgegenüber einen Durchmesser von maximal wenigen cm auf. Das heißt, mit den erfindungsgemäß hergestellten großen Wafern können bei gleichen Handlings-Zeiten wesentlich mehr Bauelemente (Schaltkreise) als mit den herkömmlichen monokristallinen SiC-Wafern hergestellt werden.

In der Zeichnung ist das erfindungsgemäße Verfahren anhand eines Fließschemas näher erläutert.

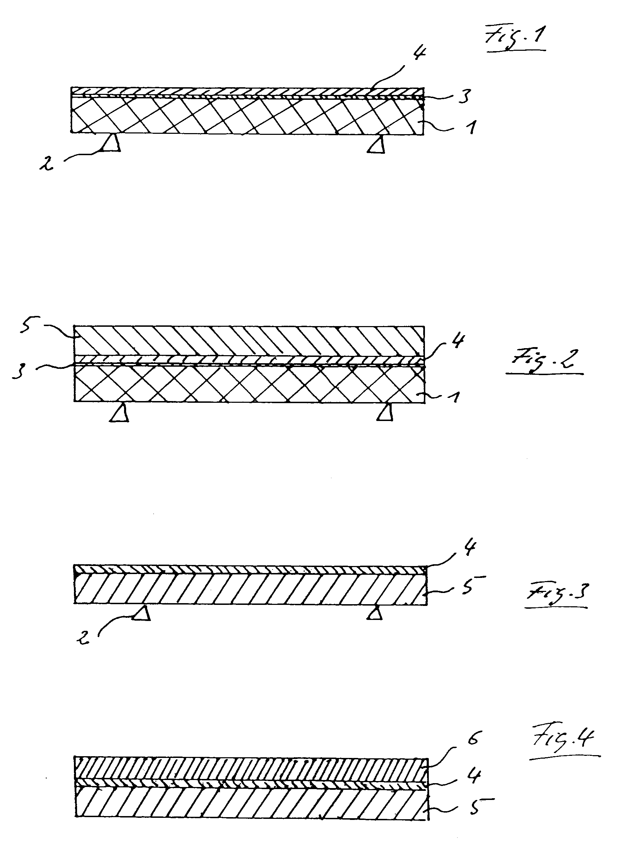

Danach wird gemäß Fig. 1 monokristallines Siliciumsubstrat 1, das auf einem Substrathalter 2 angeordnet ist, in einer nicht dargestellten Kammer erhitzt, wobei nach der Carbonisierung der Oberfläche des Siliciumsubstrats 1 unter Bildung einer Keimbildungsschicht 3 eine monokristalline SiC-Schicht 4 durch Hetero-Epitaxie-Aufwachsen abgeschieden wird.

Gemäß Fig. 2 wird dann aus der Gasphase eine polykristalline SiC-Schicht 5 auf der Mono-SiC-Schicht 4 abgeschieden.

Anschließend wird der Verbund aus monokristallinem Si-Substrat 1, einschließlich Keimbildungsschicht 3, sowie monokristalliner SiC-Schicht 4 und polykristalliner SiC-Schicht 5 abgekühlt, das monokristalline Si-Substrat 1 naßchemisch entfernt und der gebildete Verbund aus polykristalliner Siliciumcarbid-Schicht 5 als Träger und monokristalliner Siliciumcarbidschicht 4 so angeordnet, daß die polykristalline Siliciumcarbidschicht 5 auf dem Substrathalter 2 liegt. Die Keimbildungsschicht 3 kann vorher gegebenenfalls entfernt werden.

Alsdann wird gemäß Fig. 4 eine zweite, defektarme monokristalline Siliciumcarbidschicht 6 auf die erste monokristalline Siliciumcarbidschicht 1 (ggf.mit der Keimbildungsschicht 3) aufwachsen gelassen, so daß der in Fig. 4 dargestellte Verbund aus polykristalliner Siliciumcarbidschicht 5, erster monokristalliner Siliciumcarbidschicht 4 und defektarmer zweiter monokristalliner Siliciumcarbidschicht 6 gebildet wird.

Das nachstehende Beispiel dient der weiteren Erläuterung der Erfindung.

In einem Reaktor wird auf einem Substrathalter eine monokristalline Si-Substrat-Scheibe mit einem Durchmesser von 75 mm gegeben. Der Substrathalter wird auf eine Temperatur von 1360°C erwärmt. Dem Reaktor wird bei reduziertem Druck ein Gemisch aus Wasserstoff und Methan zur Carbonisierung der Oberfläche der Si-Substratscheibe zugeführt, und zwar mit einem Massenfluß von 500 cm³/min H₂ und 50 cm³/min CH₄. Die Carbonisierung ist nach wenigen Minuten abgeschlossen.

Zur Bildung der monokristallinen SiC-Schicht wird dem Reaktor bei gleicher Temperatur des Substrathalters ein Gemisch aus Wasserstoff, Methan und Silan bei reduziertem Druck zugeführt, und zwar mit einem Massenfluß von 500 cm³/min H₂, 25 cm³/min CH₄ und 15 cm³/min SiH₄, bis die Schichtdicke der monokristallinen SiC-Schicht 5 µm beträgt. Die Bildung der polykristallinen SiC-Schicht erfolgt unter den gleichen Bedingungen wie die Bildung der monokristallinen SiC-Schicht, jedoch mit einem höheren CH₄- und SiH₄-Massenfluß, nämlich 500 cm³/min H₂, 100 cm³/min CH₄ und 50 cm³/min SiH₄.

Nach dem Abkühlen wird die Si-Substrat-Schicht mit HF + HNO₃ weggeätzt. Der gebildete Wafer ist frei von Rissen und völlig eben.

## Patentansprüche

1. Verfahren zur Herstellung eines Wafers mit einer monokristallinen Siliciumcarbid-Schicht durch Epitaxie-Aufwachsen einer monokristallinen Siliciumcarbid-Schicht (4) auf einer Seite einer monokristallinen Siliciumschicht (1) zu einem Verbund aus einer monokristallinen Siliciumschicht (1) und einer monokristallinen Siliciumcarbid-Schicht (4) und Entfernen der Siliciumschicht (1), dadurch gekennzeichnet, daß man die Seite der monokristallinen Siliciumschicht (1), auf die die monokristalline Siliciumcarbid-Schicht (4) aufwächst, vor dem Aufwachsen der monokristallinen Siliciumcarbid-Schicht (4) unter Bildung einer monokristallinen Siliciumcarbid-Keimbildungsschicht (3) carbonisiert, auf der monokristallinen Siliciumcarbid-Schicht (4) des Verbundes aus monokristalliner Siliciumcarbid-Schicht (4) und monokristalliner Siliciumschicht (1) eine polykristalline Siliciumcarbid-Schicht (5) abscheidet, den so erhaltenen Verbund aus monokristalliner Siliciumschicht (1), monokristalliner Siliciumcarbid-Schicht (4) und polykristalliner Siliciumcarbid-Schicht (5) abkühlt und die Siliciumschicht (1) wegätzt, um einen Wafer aus einem Verbund aus einer monokristallinen Siliciumcarbid-Schicht (4) und einer polykristallinen Siliciumcarbid-Schicht (5) zu erhalten.

2. Verfahren nach Anspruch 1, dadurch gekennzeichnet, daß man auf der (ersten) monokristallinen Siliciumcarbid-Schicht (4) des Verbundes aus monokristalliner Siliciumcarbid-Schicht (4) und polykristalliner Siliciumcarbid-Schicht (5) durch Epitaxie-Aufwachsen eine zweite monokristalline Siliciumcarbid-Schicht (6) aufwachsen läßt, um einen Wafer aus einem Verbund aus einer polykristallinen Siliciumcarbid-Schicht (5), einer ersten monokristallinen Siliciumcarbid-Schicht (4) und einer zweiten monokristallinen Siliciumcarbid-Schicht (6) zu erhalten.

3. Verfahren nach Anspruch 1, dadurch gekennzeichnet, daß das Carbonisieren durch chemische Umsetzung eines kohlenstoffhaltigen Gases mit der Oberfläche der monokristallinen Siliciumschicht (1) erfolgt.

4. Verfahren nach Anspruch 1 oder 2, dadurch gekennzeichnet, daß nach dem Wegätzen der monokristallinen Siliciumschicht (1) die Keimbildungsschicht (3) an der Oberfläche der monokristallinen Siliciumcarbid-Schicht (4) entfernt wird.

5. Verfahren nach einem der vorstehenden Ansprüche, dadurch gekennzeichnet, daß das Epitaxie-Aufwachsen der ersten monokristallinen Siliciumcarbid-Schicht (4) und der zweiten monokristallinen Siliciumcarbid-Schicht (6) sowie der polykristallinen Siliciumcarbid-Schicht (5) aus der Gasphase erfolgt.
